Europäisches Patentamt

European Patent Office

Office européen des brevets

(11) Publication number: **0 174 224 B1**

# EUROPEAN PATENT SPECIFICATION

(45) Date of publication of patent specification: **13.06.90**

(51) Int. Cl.⁵: **G 01 R 31/28,** G 01 R 31/02

(21) Application number: **85401535.1**

(22) Date of filing: **25.07.85**

(54) **Chip on chip type integrated circuit device.**

(30) Priority: **27.07.84 JP 156618/84**
**16.11.84 JP 241977/84**

(43) Date of publication of application:
**12.03.86 Bulletin 86/11**

(45) Publication of the grant of the patent:
**13.06.90 Bulletin 90/24**

(84) Designated Contracting States:
**DE FR GB**

(56) References cited:
**EP-A-0 008 380**

**IBM TECHNICAL DISCLOSURE BULLETIN, vol.
23, no. 9, February 1981, pages 4078-4079, New
York, US; E.W. JACKSON et al.: "Module-in-
place testing autoguided probe isolation and
diagnostic technique"**

(73) Proprietor: **FUJITSU LIMITED**
**1015, Kamikodanaka Nakahara-ku
Kawasaki-shi Kanagawa 211 (JP)**

(72) Inventor: **Enomoto, Yoshinori**
**768-A-2, Kizuki Nakahara-ku
Kawaski-shi Kanagawa, 211 (JP)**
Inventor: **Monma, Hideo**
**2-3-5-401, Shirahatadai 2 chome Miyamae-ku
Kawasaki-shi Kanagawa, 213 (JP)**
Inventor: **Ohta, Shunzo**
**37-1, Aza Gonohara Ohaza Kamega Ikkicho
Aizuwakamatsu-shi Fukushima, 965 (JP)**
Inventor: **Sasaki, Takeshi**
**1287-2, Shimokodanaka Nakahara-ku
Kawasaki-shi Kanagawa, 211 (JP)**

(74) Representative: **Descourtieux, Philippe et al
CABINET BEAU de LOMENIE 55 rue
d'Amsterdam
F-75008 Paris (FR)**

**Description**

This invention relates to a chip on chip type integrated circuit (IC) which comprises a plurality of chips, mounted each on another in a single IC package. More precisely, it relates to an IC which is provided with a circuit whose function is that of checking the completeness of wiring between the chips.

As the integration becomes higher and the functions of ICs become more complicated, large scale integrating circuits (LSI) are now often required, which include various kinds of circuits in a single package. For example it is required to include CMOS (complementary MOS) circuits and TTL (transitor-transistor logic) circuits, or a CMOS digital circuit and an analog circuit in a single LSI circuit. Sometimes it is also required to include CMOS circuits in an ECL (emitter coupled logic) circuit having an interphase circuit. It is very difficult to produce such a circuit in a single chip, or even if it is possible, it cannot be expected to reach a high production yield with the present state-of-the-art technology, because it requires the provision of a circuit including both FET circuits and bipolar circuits in a single chip.

To overcome the above difficulties, it has recently been proposed that a chip on chip type structure be adopted. It is then necessary to bond a chip, fabricated according to one process sequence, with a chip which is fabricated according to another process sequence in a single package. In such a case, even although the chips are individually tested and selected before piling on each other, the reliability of the combined chips cannot be ascertained, because the wirings between the chips often create problems. Visual inspection is a powerful tool for checking the perfectness of the bondings and wirings between the chips. But it is limited only to the peripheral part of the chips.

For example in the case of chip on chip type ICs such as memory on logic or logic on logic, it is easy to check each one of the logic circuits or memory circuits before they are bonded to each other. But it is difficult to check them after they have been bonded, because the upper one is usually bonded upside down on the lower one, the chips facing each other. The upper chip does not show an electrically accessible pad and it is therefore difficult to check the wirings electrically between the upper and the lower chips.

There has also been proposed a system adapted for testing circuit assemblies that comprise electronic modules mounted on a card (EP—A—0 008 380). Here, the testing is performed between the modules themselves and between the modules and the card's input and output terminals. To achieve this, each module has an Exclusive-OR circuit that receives an input from each of the modules's input pins and a single output. Each module also has a test circuit for accessing each of the above outputs in parallel.

But the document EP—A—0008380 does not suggest how to test the perfectness of bondings in a chip-on-chip device, in which no test or control terminal can be provided on the upper chip carried on the lower chip. Also, the system disclosed in EP—A—0 008 380 can only detect whether one or more connections is/are bad, without checking each connection separately.

Such a problem has not been a serious one until now as long as the integration scale is not too large, but it is now becoming serious as the integration scale of the ICs increases as well as the number of bonds connecting the chips together.

The general object of the present invention is to increase the reliability of chips on chip type ICs by increasing the reliability of the wirings between the chips.

More particularly, the object of the present invention is to provide a means for checking the perfectness of the wirings between the chips.

In order to attain the foregoing objects, the chip or chip type IC according to the invention is provided with a checking circuit which is switched to a checking mode or to an operation mode by a control signal applied to a control terminal.

In one embodiment of the invention, two types of checking circuits are provided. The first type of checking circuit is used for checking the bonding pairs which transfer the signal from the lower chip to the upper chip, and the second type of checking circuit is used for checking pairs which transfer the signal from the upper chip to the lower chip. In both cases, when the checking circuit is switched to an operation mode, it is separated (away) from the inner logic circuit, which is the main logic circuit of the IC, and the chip operates as the original IC.

The first type of checking circuit comprises selection circuits which are provided on the lower chip and which separate the inner logic circuit from its input pads in response to the checking mode signal. The checking circuit operates then as a bypass circuit between each of the input pads and output pads of the chip. The ouptut pads of the lower chip being bonded respectively to the input pads of the upper chip, in order to operate as a chip on chip type IC, a checking signal sent from a test terminal of the lower chip is thus transferred to the upper chip bypassing the inner logic circuit. The upper chip is provided with a circuit which returns the checking signal to a specific output pad of the upper chip connected to a first detection terminal of the lower chip. Therefore, it is possible to check the perfectness of the wiring by checking the output signal appearing on the first detection terminal on the lower chip.

When the checking of a first bonding pair is over, the next ones are checked by successively selecting the corresponding bonding pads one afer the other. This checking operation is performed by means of conventional chip checking equipments, such as a probing tester for example, and does not need any specially designed tools.

The second type of checking circuit which is used for checking the signal path from the upper chip to the lower chip, operates similarly to the first type of checking circuit.

In a second embodiment of the invention, only one type checking circuit is used for testing the bonding pairs between the lower and upper chips, when said bonding pairs are commonly used for transferring signals from the lower chip to the upper chip and from the upper chip to the lower chip.

The lower chip has a first inner circuit and a plurality of first electrodes and the upper chip has a second inner circuit and a plurality of second electrodes, the upper chip being connected to the lower chip by connection of the second electrodes to at least a part of the first electrodes.

The checking circuit comprises: a test terminal provided on the lower chip for receiving a test signal; a control terminal provided on the lower chip for receiving a first control signal which designates a normal operation mode, and a second control signal which designates a checking mode; a selector provided on the lower chip and connected to the first inner circuit, the test terminal, the control terminal and said part of the first electrodes, said selector transferring operation signals from the first inner circuit to the second inner circuit in response to the first control signal and transferring test signals from the test terminal to the upper chip in response to the second control signal; means provided on the upper chip and connected to the second electrodes for receiving each test signal from the lower chip and outputting a receiving test signal or a signal responsive to the received test signal as an output signal to the lower chip; and a detection terminal provided on the lower chip and connected to at least one of the first electrodes for detecting said output signal received from the upper chip.

The invention will be more readily understood from the reading of the following description of preferred embodiments which is made hereinafter with reference to the accompanying drawings.

Brief Description of the Drawings

Fig. 1 is a schematic plan view of a chip of a chip or chip type IC according to the present invention, illustrating where the checking circuits and the input and output pads are located on the chip.

Fig. 2 is a cut view of a chip or chip type IC package, illustrating how the chips are bonded and wired to each other in a package.

Fig. 3 shows schematically a beam lead structured chip.

Fig. 4 is a cut view of a chip on chip type IC package illustrating the bonding and wiring of a beam lead type chip on the package.

Fig. 5 shows a circuit diagram for an embodiment of a checking circuit provided in an IC according to the present invention for checking the bonding which transfer the signals from a lower chip to an upper chip.

Fig. 6 is a block diagram of a checking circuit provided in an IC according to the present invention for checking the bondings which transfer the signals from an upper chip to a lower chip.

Fig. 7 is a block diagram of a modified circuit of Fig. 5 which enables the bondings to be checked by using only one kind of checking circuit.

Same or like reference numerals designates same or corresponding parts throughout the drawings, and underlined reference numerals indicate one among a plurality of said elements in each figure.

Description of preferred Embodiments

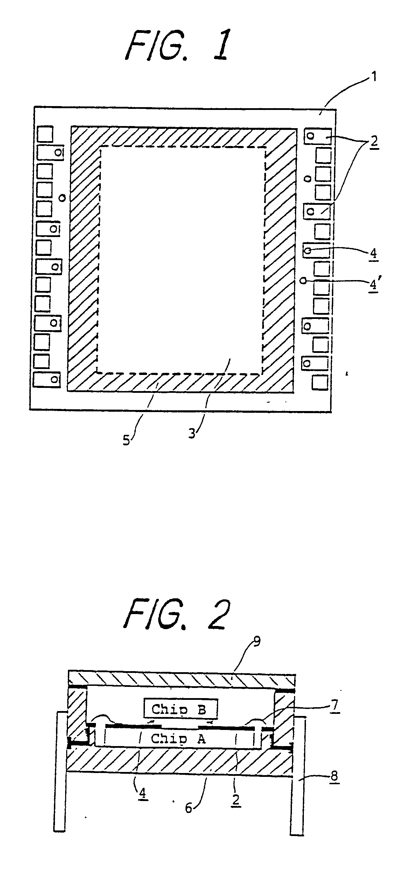

Fig. 1 is a schematic plan view of a lower chip 1 which is to be mounted in an IC package in a chip on chip type IC device according to the invention. The chip 1 is provided on its periphery with a plurality of bonding pads 2, which are connected to the inner circuit 3 of the chip (the connections not being shown for the sake of simplicity) and serve as input and output terminals of the chip. Usually, bonding pads are located both on the upper and the lower sides of the chip 1, but only one side is shown for the sake of simplicity.

As can be seen in Fig. 1, there are two kinds of bonding pads. The smaller ones are ordinary pads which are to be bonded to output pins of the package. The other ones are longer and are provided with a bump 4 (thereon). The bumps are used to bond the upper and lower chips of the chip on chip IC and, at the same time, they serve as wirings between the upper and lower chips. Some isolated bumps 4' may be provided which are not located on bonding pads, but are connected to the inner circuit 3 or to ordinary bondings pads 2, depending on the circuit design of the upper and lower chips.

An I/O (input/output) area 5 including various I/O circuits is located between the inner circuit 3, which is a main circuit of the IC, and the bonding pads 2. Usually, the I/O circuits contain large transistors, so they are located at the peripheral part of the chip to avoid interaction with the inner circuit. The checking circuit according to the present invention is fabricated in the I/O area 5.

The upper chip has a form similar to that of the lower chip shown in Fig. 1. But it is designed to be smaller than the lower chip so that the peripheral bonding pads area of the lower chip remains exposed when the upper chip is mounted on the lower chip. The bumps of the upper chip are positioned to face respective bumps of the lower chip when the chips are assembled.

Fig. 2 shows a cut view of a chip on chip type IC illustrating how the bumps are bonded. The lower chip (which will be referred to as chip A hereinafter) is mounted on a package 6, and the upper chip (which will be referred to as chip B hereinafter) is placed with its face bearing the bumps turned downwardly, so that the corresponding bumps of the chips A and B face each other. In Fig. 2, the size of the bonding pads 2 and of the bumps 4 are shown enlarged compared to other parts in order to make the structure of the bonding parts more clearly apparent. The bonding of the chips A and B is performed for example by thermal-compression bonding. The bonding pads 2 are connected by means of respective wires 7 to corresponding pads on the package 6 which are electrically connected to respective pins 8. The package is covered and sealed by a lid 9.

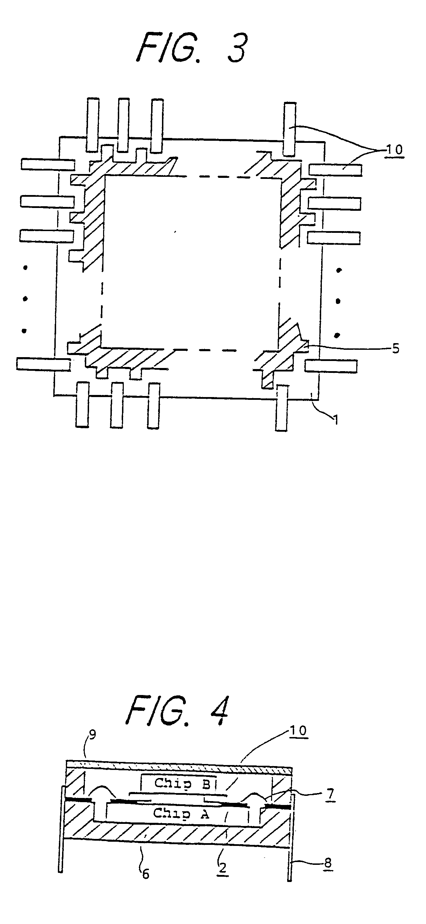

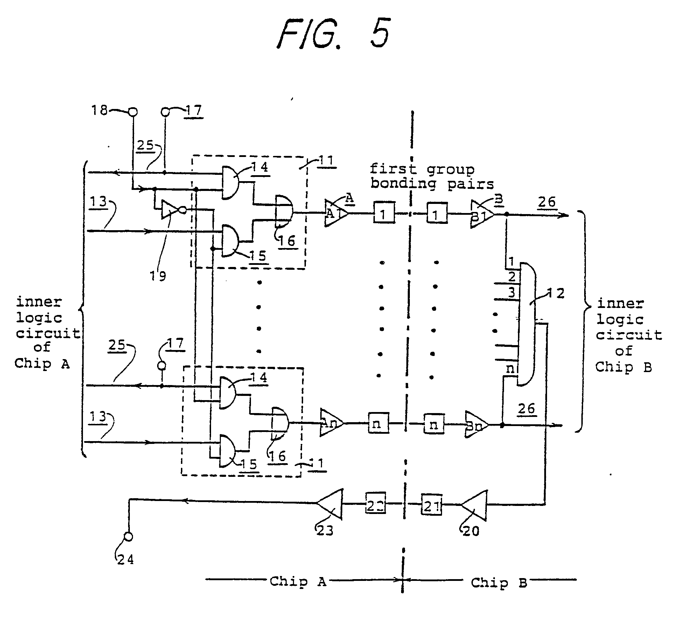

Figs. 3 and 4 show another embodiment of a chip on chip type IC having a beam lead structure. In Figs. 1 and 2 and in Figs. 3 and 4, reference numerals designate similar parts. In the embodiment shown in Figs. 3 and 4, the connections between the chip A and the chip B are made by beam leads 10, whic are bonded to the bonding pads on the chip A by thermal-compression bonding, for example.

Fig. 3 shows schematically a plane view of a beam lead structured chip B (the upper chip). The bonding pads 2 or the bumps 4 or 4' of the chip of Fig. 1 are replaced by beam leads 10. The I/O area 5, wherein the checking circuit according to the present invention is fabricated, is positioned at the peripheral part of the chip A. Fig. 4 shows a cut view of the chip on chip type IC with a chip B having a beam lead structure. The beam leads 10 shown in Fig. 3 (as well as the bumps 4 or 4' of Fig. 1) are fabricated by photolithographic masking and electrical plating for example. Such a beam lead structure is well known in the art, so that further explanations may be omitted.

Many other bonding methods may be used for bonding the upper chip to the lower chip, but as mentioned before, the present invention is concerned with a means for checking the perfectness of the bondings and wirings between the chips, and is not concerned with a particular bonding method, so that, further description relative to the bonding and the structure of the chips will be omitted hereinafter.

Each of the chips is tested electrically by contacting the bonding pads to test equipment before the chips are installed on a package, but there is no way to check thereafter the wirings between the chips, though a test is conducted on the completed IC after the packaging is finished. But the check of the bonding between the chips is important to increase the reliability and yield of the IC, because it provides data to analyse the reason for rejection and helps in developing methods to improve the production process, including the bonding process.

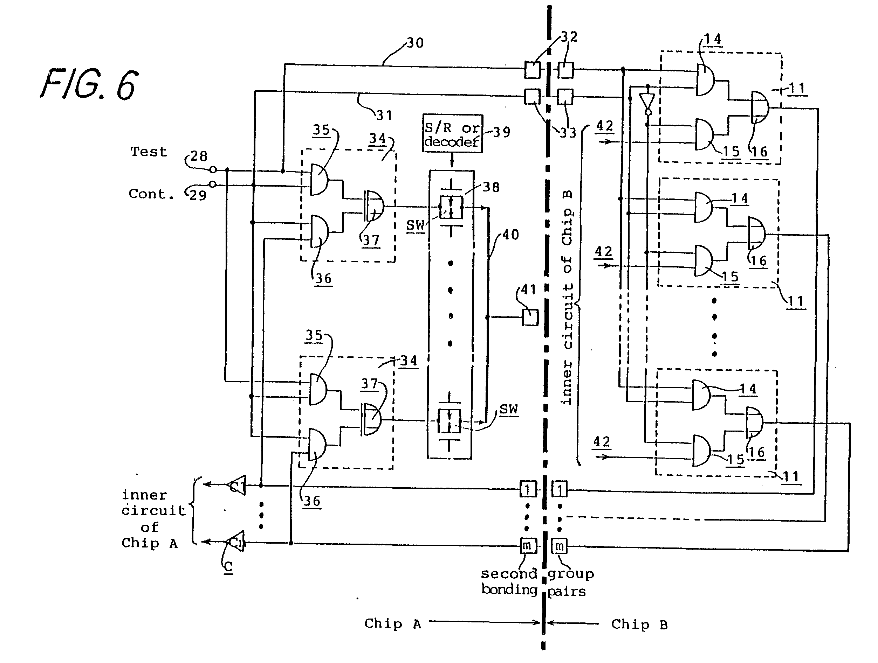

Fig. 5 and 6 show circuit diagrams of checking circuits according to an embodiment of the present invention. These circuits are located on the peripheral area of the chip together with the I/O circuits of the chip. The checking circuit operates as a connection circuit between the bonding pads 2 and the inner circuit 3 in a normal operation mode. But in a test mode, it separates the inner circuit 3 from the bonding pads and operates as a circuit bypassing the inner circuit 3, and being interconnected between the input bonding pads 2 and the bumps 4 or 4' of which the connections are to be checked.

As mentioned before, the checking circuit means in the IC according to the present invention includes two types of circuits. The first type is used to check the bondings through which signals from the lower chip (chip A) are transferred to the upper chip (chip B). These bonding pairs facing each other on the chips to be bonded are referred to as bonding pairs of a first group. The second type is used to check the bondings through which signals from the chip B are transferred to the chip A, and which are referred to as bonding pairs of a second group. The numbers of the bonding pairs included in the first and in the second groups are not always equal to each other.

A circuit of the first type which is shown in Fig. 5 will be explained first. This circuit is divided into two parts separated by a chained line in the figure. The circuit part shown on the left hand side of the chained line is fabricated on the lower chip (chip A). The circuit part shown on the right hand side of the chained line is fabricated on the upper chip (chip B). Both circuit parts are fabricated by means of a conventional process at the same time as the other circuits of the chip are fabricated.

In Fig. 5, the rectangles on both sides of the chained line represent the bumps 4, 4' or beam leads 10 which bond the chip A and chip B together as shown in Figs. 1—4. The present invention intends to check electrically the perfectness of the bondings across the chained line; more precisely, it checks the bonding pairs of the first group, the bonding pairs of second groups not being shown in Fig. 5 for the sake of simplicity. The number of bonding pairs is supposed to be equal to n, as shown in the figure. A selection circuit 11 encircled with a broken line is provided on the chip A for each of the bonding pairs. The selection circuits are connectd to respective bonding pairs via output buffer circuits A (denoted as Al-An in Fig. 5). On the chip B, each of the bonding pairs is connected to the input terminal of an n-input AND gate 12 via respective input buffer circuits B (denoted as Bl-Bn). The output terminals of the input buffer circuit B are also connected to respective circuit points of the inner logic circuit of the chip B (not shown), to which the bonding pairs should be connected. Similarly, the selection circuits 11 on the chip A are provided with input lines 13 which are connected to respective circuit points of the inner logic circuit of the chip A (not shown), to which the bonding pairs should be connected.

Each of the selection circuits 11 comprises two AND gates 14, 15 and an OR gate 16. The first and second input terminals of the first AND gate 14 are connected to a test terminal 17 and a control terminal 18, respectively. These terminals are two of the bonding pads 2 in Fig. 1, respectively. The control terminal 18 needs to be provided independently from the original bonding pads fabricated on the chip A. But the test terminals 17 can be used both for the testing and as original bonding pads fabricated for the original IC circuit. Therefore, the test terminals 17 may be connected to the inner circuit 3 (not shown) by wiring lines 25. The control terminal 18 is also connected to one of the input terminals of each of the second AND gates 15 via a common inverter 19.

The other input terminals of the second AND gates *15* are connected to respective circuit points in the inner circuit of the chip A via wiring lines *13*. The outputs of the AND gates *14* and *15* are supplied to the first and second input terminals of the OR gates *16*. And the output terminals of each OR gate *16* are connected to respective bonding pairs via respective buffer amplifiers Al-An. The test terminals *17* and the wiring lines *13* are provided for each of the selection circuits *11*, hence for each of the bonding pairs. But the control terminal 18 and the inverter gate 19 are commonly used for all the selection circuits *11*, hence for all of the bonding pairs.

On the chip B, the output of the n-input AND gate 12 is supplied to an output bonding pad 21 via an output buffer circuit 20. The output bonding pad 21 is bonded to the bonding pad or bump 22 in the chip A. The pads 21 and 22 are bonded to each other to form a bonding pair at the same time as the other bumps or beam leads are bonded. The bonding pad or bump 22 is connected to a detection terminal 24 via an input buffer circuit 23.

Operation of the checking circuit is as follows. In an operation mode, the control terminal 18 is supplied with a signal "0", so that the outputs of the first AND gates *14* are "0", regardless of the fact that the signal on the terminals *17* is "0" or "1". Therefore, the test circuit is substantially separated from the inner circuit 3, and the terminals *17* are connected to the inner circuit 3 by the wiring lines *25*. The output signals from the inner circuit 3 appearing on the lines *13* are respectively supplied to first input terminals of the second AND gates *15*, whose second input terminals are supplied with a signal "1" from the inverter 19. Therefore, a signal "0" or "1" appears at the output of the second AND gates *15* depending on the "0" or "1" signal on the respective lines *13*. The output signals of the first AND gates *14* are "0", so that the output signals from the OR gates *16* are "0" or "1" depending on the output signal of the gates *15*, hence depending on the output signal of the inner circuit 3. This implies that the inner circuit 3 is substantially connected to its respective output terminals (that is the bumps of the bonding pair) via the selection circuits *11* and the output buffer circuits *A*. The signals at the bonding pairs are transferred to the inner circuit of the chip B. In the chip B, the signals transferred from the chip A are sent to respective circuit points of the inner circuit (not shown) via the input buffers *B* and lines *26*. Thus the IC performs its normal operation.

In a checking mode, the control terminal 18 on the chip A in Fig. 5 is supplied with a signal "1", so that the signals coming out from the inner circuit 3 (not shown) via the connection lines *13* cannot pass through the second AND gates *15*, since the second input terminals of the AND gates *15* are supplied with an "0" signal from the inverter 19. The outputs of the second AND gates *15* are always "0" regardless of the fact that the output signals from the inner circuit 3 are "0" or

"1". On the contrary, the output of the first AND gates *14* is "0" or "1" depending on the "0" or "1" signals applied to the test terminals *17*, since the second input terminals of the AND gates *14* are supplied with a signal "1" from the control terminal 18. Therefore, the output signals of the OR gates *16* are "0" or "1" depending on the input signals applied to the test terminals *17*, since the second terminals of the OR gates *16* are supplied with "0" signal from the second AND gates *15*. The output signals of the OR gates *16* are sent to the chip B via the output buffer circuits *A* and the bonding pairs.

In the chip B, the signals issuing from the bonding pairs are sent to respective input terminals of the n-input OR gate 12, via the respective input buffer circuits *B*.

The check is performed one after another on each of the bonding pairs. Namely, one of the test terminals *17* is selected and supplied with "0" and "1" signals, the remaining test terminals being supplied with "0" signal. Then it will be understood that the output signal of the n-input AND gate 12 is "0" or "1" depending on the signal applied to the selected test terminal, since all other input terminals of the gate 12 are supplied with "0" signals. This signal is sent back to the chip A via the output buffer circuit 20 and the bonding pair 21, 22. In the chip A the signal issuing from the bonding pair 22 is led to the detection terminal 24 via the input buffer circuit 23.

Therefore, if the output signal, at the detection terminal 24 is compared with the signal applied to the selected test terminal *17*, it is possible to check the perfectness of the bonding corresponding to the selected test terminal. When the check for one terminal, that is for one bonding pair, is finished, the test for the next terminal begins in a manner similar as described above. It will be clear for anyone with ordinary skill in the art that such a test can be performed easily by applying a wafer probing tester for example.

From the above explanation, it will be understood that the additional bonding pads required for the checking circuit of Fig. 5 are only two, that is one for the control terminal 18 and the other one for the detection terminal 24. This last mentioned terminal is referred to as the first detection terminal hereinafter. The bonding pads for the other terminals, for example the ones for the test terminal *17*, can be used commonly with the I/O terminals of the chips, that is the bonding pads *2* in Fig. 1.

As mentioned before, the checking circuit of Fig. 5 is applicable for testing the bonding pairs of first group. It is indeed clear when examining the circuit of Fig. 5, that the selection circuits *11* transmit signals only from left to right. Therefore, it cannot be applied to the testing of the bonding pairs of the second group. It is then necessary to provide another circuit for checking the bonding pairs of the second group, that is the group of bonding pairs which transmit the signal from the upper chip to the lower chip. Moreover in Fig. 5, the bonding pairs of the second group are not shown explicitly, for the sake of simplicity, and, it should then be kept in mind that, in an actual chip on chip device there are more bonding pairs than those shown in this figure.

Now a circuit applicable to check the second bonding pairs group, i.e. a checking circuit of the second type, will be described referring to Fig. 6. In the figure, the circuit on the left hand side of the chained line denotes the circuit fabricated on the lower chip (chip A), and the one on the right hand side of the chained line denotes the circuit fabricated on the upper chip (chip B). As mentioned before, since the chip B is turned upside down to be bonded on the chip A, there is no accessible bonding pad for an outer test equipment. Therefore particular means is necessary for checking the bonding pairs from the chip A.

As shown in Fig. 6, a second test terminal 28 and a second control terminal 29 are provided. The second control terminal 29 can be used in common with the control terminal 18 in Fig. 5. The external terminals 28 and 29 are connected to the chip B via wiring lines 30, 31 and bonding pairs 32 and 33, respectively. Thus, the chip B is provided with external pads to be contacted by an external test equipment, said external pads being in fact formed on the chip A.

If the number of the second group bonding pairs to be checked is m, an equal number of selection circuits 11 is provided on the chip B. These selection circuits are similar to the ones shown in Fig. 5. As can be seen in Fig. 6, the first and second inputs of the AND gates 14 of the selection circuits 11 are respectively connected in parallel to the test terminal 28 and the control terminal 29 via the bonding pairs 32 and 33. The output terminals of the selection circuits 11 are connected respectively to the bonding pairs 1-m.

On the chip A, comparing circuits 34 are provided in a number equal to the numer m of second group bonding pairs. Each circuit 34 is shown encircled with a broken line and comprises a third AND gate 35, a fourth AND gate 36 and an EXCLUSIVE-OR gate 37. A first one of the two input terminals of each third AND gate 35 is connected to the second test terminal 28. The second input terminal of each third AND gate 35 and a first one of the two input terminals of each fourth AND gate 36 are connected in common to the second control terminal 29. The second input terminals of the fourth AND gates 36 are connected respectively to the second group bonding pairs 1-m. The output terminals of the third and fourth AND gates 35 and 36 are connected to respective input terminals of the EXCLUSIVE OR gates 37. The outputs of the gates 37 constitute the outputs of the comparing circuits 34 and are fed to a switch array 38, which is controlled by a shift register (S/R) or a decoder 39.

Operation of the checking circuit of Fig. 6 is as follows. In the operation mode, a control signal "0" is applied to the control terminal 29. Then, as described with respect to Fig. 5, the test terminal 28 is separated by the selection circuits 11 away from the inner circuit (not shown) of the chip B. The chip B is operated by the signals coming from the first group bonding pairs (not shown), and the output of the inner circuit appears on the lines 42. These signals are applied to the second inputs of the AND gates 15 in the selection circuits 11 and are sent to respective bonding pairs 1-m, via the selection circuits 11, in a manner similar to that described beforehand, and transferred to the chip A.

In the chip A, the comparing circuits 34 are separated away from the bonding pairs 1-m, since the first input terminals of their fourth AND gates 36 are supplied with "0" signal from the control terminal 29. The signals issuing from the chip B are sent to the inner circuit of the chip A (not shown) via buffer circuits C (denoted as Cl-Cm), so that the chips A and B operate as combined IC. The inner circuits of the chip A and chip B are hereinafter referred to as inner circuit A and inner circuit B respectively.

In the checking mode, the control terminal 29 is supplied with a signal "1", and the test terminal 28 is supplied with a test signal varying from "1" to "0". Therefore the selection circuits 11 substantially separate the inner circuit B (the lines 42) from the bonding pairs 1-m, and send the test signal to said bonding pairs 1-m.

On the chip A, the signals returning from the chip B are respectively supplied to the second input terminals of the fourth AND gates 36, and are compared with the test signal directly coming from the test terminal 28. The logic of the comparison is as follows. When the test signal supplied to the terminal 28 varies from "1" to "0" (1 0), the output of the third AND gates 35 varies as (1 0), since their other terminals are supplied with a "1" from the terminal 29. If the bondings of the bonding pairs 1-m are perfect and the same signals varying as (1 0) appear on the bonding pairs 1-m, the output of the fourth AND gates 36 will also vary as (1 0), so the outputs of the EXCLUSIVE OR gates 37 are (0 0). But if any one of the bonding pairs is imperfect, and the corresponding signal received by the chip A varies otherwise, namely (0 0), (1 1) or (0 1), the output of the corresponding gate 36 will vary as (0 0), (1 1), or (0 1). Hence, the output of the corresponding EXCLUSIVE OR gate 37 will vary as (1 0), (0 1) or (1 1). Therefore, if the bondings are perfect, the output signals of the corresponding circuits 34 will all become "0"; on the contrary, if the bondings are not all perfect, the output signals will include at least one "1" signal.

These output signals are fed respectively to a switching gate SW in the swith array 38. The switches SW may be of any kind; as illustrated, they are formed by a pair of p-channel and n-channel FETs. The switches are controlled by a shift register (S/R) or a decoder 39, which selects the switches SW one after another and transfers successively the output signals of the comparing circuits 34 to a detection terminal 41 via a line 40. Thus it is possible to check the perfectness of the second group bonding pairs by checking whether the signal at the detection terminal 41 includes "1" or not. The checking operation can be performed by using a conventional probe checker.

In the above explanation, it will be understood that the bonding pads or bumps required to be added to the original IC circuit for the circuit of Fig. 6 are the bonding pairs 32, 33, the output terminal 41 and the test terminal 28. The control terminal 29 and that 18 of the circuit of Fig. 6 may be formed by one and same terminal. The terminal 41 will be referred to as second detection terminal hereinafter.

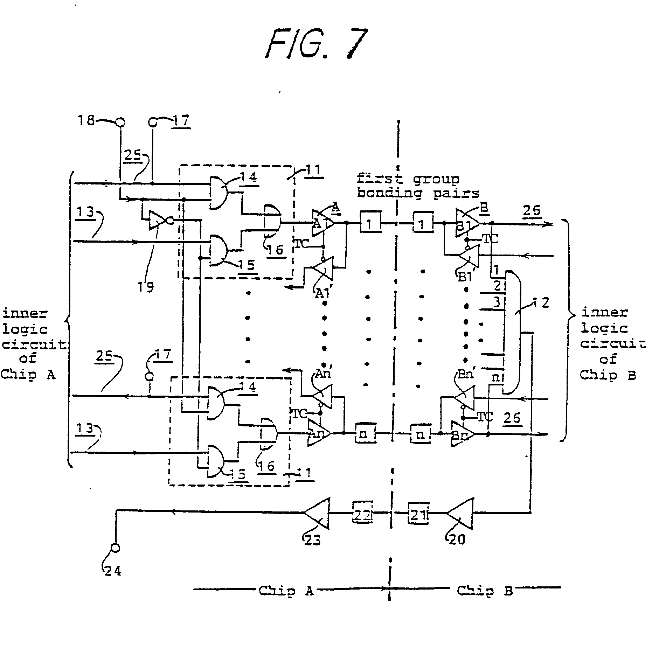

In the above disclosure, it has been assumed that the bumps 1-n of the chip A and 1-m of chip B are all exclusively used for input or output signals. Therefore, it was necessary to provide both the circuits of Figs. 5 and 6. But if the bumps are commonly used for transferring signals from the chip A to the chip B and from the chip B to the chip A, and if the chips A and B are provided with tri-state buffer circuits, it is possible to execute the test only by a circuit similar to that of Fig. 5. Such a modification is shown in Fig. 7.

The differences between the circuits of Fig. 7 and Fig. 5 are as follows: The chip A is provided with input buffer circuits Al'-An', the chip B is provided with output buffer circuits Bl'-Bn', and all buffer circuits Al-An, Al'-An', Bl-Bn, and Bl'-Bn' are formed by tri-state buffer circuits. In Fig. 7, TC designates a tri-state control signal. When the TC signal is "1", the buffer circuits Al-An and Bl-Bn are turned to the enable state, and the buffer circuits Al'-An" and Bl-Bn' are turned to the disable state. On the contary, when the TC signal becomes "0", the buffer circuits Al-An and Bl-Bn are turned to the disable state, and the buffer circuits Al'-An' and Bl'-Bn' are turned to the enable state. In both cases, the output impedance of the buffer circuits in the disable state is high. The outputs of the buffer circuits Al'-An' are supplied to the inner logic circuit A, and the buffer circuits Bl'-Bn' are supplied with the output signals of the inner logic circuit B.

In Fig. 7, it will be clear, that, when the checking is executed, the tri-state signal TC is kept to "1" state. The buffer circuits Al'-An' and Bl'-Bn' are thus substantially separated from the bumps, and it is possible to check the bondings in a manner similar to that described with respect to Fig. 5.

As has been described above, the checking circuits in the IC according to the present invention make it possible to check the perfectness of bonding pairs in chip on chip type ICs, and thus increases the reliability of such ICs. And it will be clear that such checking circuit is applicable to any type of ICs. Various modifications may be made to the above described embodiments without departing from the scope of the present invention. For example, the control signals may be inverted, with a small modification of the checking circuits.

**Claims**

1. Chip-on-chip type integrated circuit (IC) equipped with a checking circuit to check electrically the perfectness of bondings between the two interconnected chips forming said chip-on-chip Ic, each said chip being provided with a respective set of bonding pads in such manner as to form a set of bonding pairs between said interconnected chips, said checking circuit comprising:
a control terminal (18, 29) provided on a first chip (A) for receiving a control signal or a check mode signal for switching said checking circuit to an operation mode or to a checking mode;
a test terminal (17, 28) provided on the same chip (A) for receiving a test signal;
checking circuit means for checking bonding pairs (1-n) which bonding pairs (1-n) transfer signals from the first chip (A) to the second chip (B); and
at least one detection terminal (24, 41) to which a signal appears indicating the perfectness of the bonding pairs,
characterized in that the two interconnected chips form a chip-on-chip IC (integrated circuit) device in which the second chip (B) is carried by the first chip (A), these chips facing each other wherein signals are transferred from the first chip (A) to the second chip (B) through a first group of bonding pairs (1-n), and from the second chip (B) to the first chip (A) through a second group of bonding pairs (1-m), that the checking circuit comprises, in addition to said (first) checking circuit means, a second checking circuit means for checking the second group of bonding pairs (1-m), each checking circuit means having test (17, 28) control, (18, 29) and detection (24, 41) terminals all provided on the first chip, the first as well as the second checking circuit means carrying out separate check of each bonding pair of said two groups (1-n, 1-m).

2. Chip-on-chip type IC according to claim 1, characterized in that:
the first type checking circuit comprises:
a plurality of selection circuits (11, Fig. 5) provided on the first chip (A), each of which, when receiving the operation mode signal, substantially separates the checking circuit from an inner circuit of the first chip (A) and connect a respective pair of a first group of bonding pads (1-n) to a respective inner circuit point of the first chip (A), and, when receiving the check mode signal, substantially separates said inner circuit point from said pair of bonding pads and transmit the test signal applied to a respective test terminal (17) through said pair of bonding pads to the second chip (B); and
a multi-input AND gate (12) provided on the second chip (B), of which input terminals are operationally connected to the first group bonding pairs (1-n), respectively, the output signal of said multi-input AND gate being sent back to the first chip (A) and transferred to the first detection terminal (24); and
the second type checking circuit comprises:
a first bonding pair (32) to transmit the test signal applied to the test terminal to the second chip (B);

a second bonding pair (33) to transmit the control signal aplied to the control terminal to the second chip (B);

a plurality of selection circuits (*11*, Fig. 6) provided on the second chip (B) which, when receiving the operation mode signal from the second bonding pair (33) substantially separate the checking circuit from a second inner circuit of the second chip (B) and connect output lines (*42*) of the second inner circuit to respective second group bonding pairs (1-m), and, when receiving the check signal, substantially separate the second inner circuit from said output lines (*42*) and transmit the test signals from the second bonding pair (33) to respective second group bonding pairs (1-m); and

a plurality of comparing circuits (*34*) provided on the first chip (A) which, when receiving the operation signal, are substantially separate from the first inner circuit, and, when receiving the check mode signal, compare the signals appearing on each of the second bonding pairs (1-m) with the test signal directly received from the test terminal (28).

3. Chip-on-chip type IC according to claim 2, characterized in that each of said selection circuits (*11*) comprises:

a first AND gate (*14*) of which one input terminal receives the test signal, and the other input terminal receives the control signal;

a second AND gate (*15*) of which one input terminal receives an output signal from the inner circuit, and the other input terminal receives the reversed control signal; and

an OR gate having two input terminals connected to the output terminals of the first and the second AND gates respectively, and an output terminal operationally connected to a respective one of the bonding pairs to be checked.

4. Chip on chip type IC according to any one of claims 2 and 3, characterized in that each of said comparing circuits (34) comprises:

a third AND gate (*35*) having input terminals which receive the test signal and the control signal respectively;

a fourth AND gate (*36*) of which one input terminal receives the control signal and the other input terminal receives the signals coming out from a respective one of said second group bonding pairs (1-m); and

an EXCLUSIVE-OR circuit (*37*) having input terminals connected to the output terminals of the third and the fourth AND gates respectively, and an output terminal operationally connected to the second detection terminal (41).

5. Chip on chip type IC according to any one of claims 2 to 4, characterized in that it further comprises a switching means (38) for switching the outputs of said comparing circuits (*34*) to said second detection terminal (41) one after the other.

6. Chip on chip type IC according to claim 5, characterized in that said switching means comprises an array of switching gates (*SW*) comprising parallel connected p-type and n-type FETs.

7. Chip on chip type IC according to any one of claims 2 to 6, characterized in that the numbers of said selection circuits (*11*) in the first type and the second type checking circuits are respectively equal to the number (n) of the first group bonding pairs and to the number (m) of the second group bonding pairs, and the number of the input terminals of the multi-input AND gate (12) is equal to that (n) of the first group bonding pairs.

8. Chip on chip type IC according to any one of claims 2 to 7, characterized in that the bonding pads used for the test terminals (17) of the first type checking circuit are common to bonding pads of the original IC.

**Patentansprüche**

1. Integrierte Schaltung (IC) vom Chip-auf-Chip-Typ, mit einer Prüfschaltung, um elektrisch die Perfektheit der Bindungen zwischen den zwei miteinander verbundenen Chips zu prüfen, welche den Chip-auf-Chip-IC bilden, wobei jedes genannte Chip einen entsprechenden Satz von Verbindungspads in solch einer Weise aufweist, daß sie einen Satz von Verbindungspaaren zwischen den genannten miteinander verbundenen Chips bilden, welche genannte Prüfschaltung umfaßt:

einen Steueranschluß (18, 29), der auf einem ersten Chip (A) vorgesehen ist, um ein Steuersignal oder ein Prüfmodussignal zum Schalten der genannten Prüfschaltung in einen Betriebsmodus oder in einen Prüfmodus aufweist;

einen Testanschluß (*17*, 28), der auf demselben Chip (A) vorgesehen ist, um eine Testsignal zu empfangen;

eine Prüfschaltungseinrichtung, zum Prüfen der Verbindungspaare (1-n), welche Verbindungspaare (1-n) Signale von dem ersten Chip (A) zu dem zweiten Chip (B) übertragen; und

wenigstens einen Detektionsanschluß (24, 41), an dem ein Signal erscheint, welches die Perfektheit der Verbindungspaare anzeigt, dadurch gekennzeichnet, daß die beiden miteinander verbundenen Chips eine Chip-auf-Chip-IC-(integrierte Schaltung)-Vorrichtung bilden, in welcher der zweite Chip (B) von dem ersten Chip (A) getragen wird, wobei diese Chips einander zugewandt sind und Signale von dem ersten Chip (A) über eine erste Gruppe von Verbindungspaaren (1-n) zu dem zweiten Chip (B) übertragen werden, und von dem zweiten Chip (B) über eine zweite Gruppe von Verbindungspaaren (1-m) zu dem ersten Chip (A), daß die Prüfschaltung, zusätzlich zu der genannten (ersten) Prüfschaltungseinrichtung, eine zweite Prüfschaltungseinrichtung umfaßt, zum Prüfen der zweiten Gruppe von Verbindungspaaren (1-m), jede Prüfschaltungseinrichtung Test- (*17*, 28), Steuer- (18, 29) und Detektions- (24, 41) -anschlüsse hat, die alle auf dem ersten Chip vorgesehen sind, sowohl die erste als auch die zweite Prüfschaltungseinrichtung eine separate Prüfung von jedem Verbindungspaar der genannten beiden Gruppen (1-n, 1-m) durchführt.

2. Chip-auf-Chip-Typ-IC nach Anspruch 1, dadurch gekennzeichnet, daß:

der erste Prüfschaltungseinrichtung umfaßt:

eine Vielzahl von Auswahlschaltungen (*11*, Fig. 5), die auf dem ersten Chip (A) vorgesehen sind, von denen jede, wenn sie das Betriebsmodussignal empfängt, im wesentlichen die Prüfschaltung von einer inneren Schaltung des ersten Chip (A) trennt und ein entsprechendes Paar von einer ersten Gruppe von Verbindungspads (1-n) mit einem entsprechenden inneren Schaltungspunkt auf dem ersten Chip (A) verbindet, und, wenn sie das Prüfmodussignal empfängt, im wesentlichen den genannten inneren Schaltungspunkt von dem genannten Paar von Verbindungspads trennt und das Testsignal, das einem entsprechenden Testanschluß (17) zugeführt wird, über das genannte Paar von Verbindungspads zu dem genannten zweiten Chip (B) überträgt; und

auf dem zweiten Chip (B) ein Mehrfacheingangs-UND-Gatter (12) vorgesehen ist, von welchem Eingangsanschlüsse jeweils wirkungsmäßig mit der ersten Gruppe von Verbindungspaaren (1-n) verbunden sind, das Ausgangssignal des Mehrfacheingangs-UND-Gatters zu dem ersten Chip (A) zurückgesendet und zu dem ersten Detektionsanschluß (24) übertrgen wird; und

der zweite Prüfschaltungs einrichtung umfaßt:

ein erstes Verbindungspaar (32), um das Testsignal, das dem Testanschluß zugeführt wird, zu dem zweiten Chip (B) übertragen;

ein zweites Verbindungspaar (33), um das Steuersignal, welches dem Steueranschluß zugeführt wird, zu dem zweiten Chip (B) zu übertragen;

ein Vielzahl von Auswahlschaltungen (*11*, Fig. 6), die auf dem zweiten Chip (B) vorgesehen sind, die, wenn sie das Betriebsmodussignal von dem zweiten Verbindungspaar (33) empfangen, im wesentlichen die Prüfschaltung von einer zweiten inneren Schaltung auf dem zweiten Chip (B) trennen und Ausgangsleitungen (*42*) der zweiten inneren Schaltung mit entsprechenden zweiten Gruppen von Verbindungspaaren (1-m) verbinden, und, wenn es das Prüfsignal empfangen, im wesentlichen die zweite innere Schaltung von den genannten Ausgangsleitungen (*42*) trennen und das Testsignal von dem zweiten Verbindungspaar (33) zu entsprechenden zweiten Gruppen von Verbindungspaaren (1-m) übertragen; und

eine Vielzahl von Vergleichsschaltungen (*34*), die auf dem ersten Chip (A) vorgesehen sind, welche, wenn sie das Betriebssignal empfangen, im wesentlichen von der ersten inneren Schaltung separiert sind, und, wenn sie ein Prüfmodussignal empfangen, die auf jedem der zweiten Verbindungspaare (1-m) erscheinen den Signale mit dem direkt von dem Testanschluß (28) empfangenen Testsignal vergleichen.

3. Chip-auf-Chip-Typ-IC nach Anspruch 2, dadurch gekennzeichnet, daß jede der genannten Auswahlschaltungen (*11*) amfaßt:

ein erstes UND-Gatter (*14*), von dem ein Eingangsanschluß das Testsignal empfängt und der Andere Eingangsanschluß das Steuersignal empfängt;

ein zweites UND-Gatter (*15*), von dem ein Eingangsanschluß ein Ausganssignal von der inneren Schaltung empfängt und der andere Eingangsanschluß das invertierte Steuersignal empfängt; und

ein ODER-Gatter, das zwei eingangsanschlüsse hat, die mit den Ausgangsanschlüssen des ersten bzw. zweiten UND-Gatters verbunden sind, und einen Ausgangsanschluß, der wirkungsmäßig mit einem entsprechenden der zu prüfenden Verbindungspaare verbunden ist.

4. Chip-auf-Chip-Typ-IC nach einem der Ansprüche 2 oder 3, dadurch gekennzeichnet, daß jede der genannten Vergleichsschaltungen (34) umfaßt:

ein drittes UND-Gatter (*35*), das Eingangsanschlüsse hat, die das Testsignal bzw. das Steuersignal empfangen;

ein viertes UND-Gatter (*36*), von dem ein Eingangsanschluß das Steuersignal empfängt und der andere Eingangsanschluß die Signale empfängt, die von einem entsprechenden der genannten zweiten Gruppe von Verbindungspaaren (1-m) kommen; und

eine EXKLUSIV-ODER-Schaltung (*37*), die Eingangsanschlüsse hat, die mit den Ausgangsanschlüssen des dritten bzw. vierten UND-Gatters verbunden sind, und einen Ausgangsanschluß, der wirkungsmäßig mit dem genannten zweiten Detektionsanschluß (41) verbunden ist.

5. Chip-auf-Chip-Typ-IC nach einem der Ansprüche 2 bis 4, dadurch gekennzeichnet, daß sie ferner eine Schalteinrichtung (38) umfaßt, zum Schalten der Ausgänge der genannten Vergleichsschshaltungen (*34*) zu dem genannten zweiten Detektionsanschluß (41), eine nach der anderen.

6. Chip-auf-Chip-Typ-IC nach Anspruch 5, dadurch gekennzeichnet, daß die genannten Schalteinrichtungen eine Anordnung von Schaltgattern (*SW*) umfassen, die parallel verbundene p-Typ und n-Typ FETs umfassen.

7. Chip-auf-Chip-Typ-IC nach einem der Ansprüche 2 bis 6, dadurch gekennzeichnet, daß die Zahlen der genannten Auswahlschaltungen (*11*) in dem ersten Typ bzw. in dem zweiten Typ von Prüfschaltungen jeweils gleich der Anzahl (n) der ersten Gruppe von Verbindungspaaren bzw. der Anzahl (m) der zweiten Gruppe von Verbindungspaaren sind, und die Zahl der Eingangsanschlüsse des Mehrfacheingangs-UND-Gatters (12) gleich derjenigen (n) der ersten Gruppe von Verbindungspaaren ist.

8. Chip-auf-Chip-Typ-IC nach einem der Ansprüche 2 bis 7, dadurch gekennzeichnet, daß die Verbindungspads, die für die Testanschlüsse (17) der Prüfschaltung vom ersten Typ verwendet werden, den Verbindungspads der originalen IC gemeinsam sind.

## Revendications

1. Circuit intégré du type puce sur puce (IC) équipé d'un circuit de contrôle permettant de contrôler électriquement le parfait état des interconnexions existant entre les deux puces interconnectées qui forment ledit circuit intégré puce sur puce, chaque dite puce étant dotée d'un ensemble respectif de plots d'interconnexion de manière à former un ensemble de paires d'interconnexions entre lesdites puces interconnectées, ledit circuit de contrôle comprenant:

une borne de commande (18, 29) placée sur une première puce (A) de façon à recevoir un signal de commande ou un signal de mode de contrôle permettant de faire commuter ledit circuit de contrôle dans un mode de fonctionnement ou dans un mode de contrôle;

une borne de vérification (17, 28) placée sur la même puce (A) afin de rcevoir un signal de vérification;

un moyen formant un circuit de contrôle qui sert à contrôler des paires d'interconnexions (1 à n), lesquelles paires d'interconnexions (1 à n) transfèrent des signaux de la première puce (A) à la deuxième puce (B); et

au moins une borne de détection (24, 41) sur laquelle apparaît un signal indiquant l'état de perfection des paires d'interconnexions,

caractérisé en ce que les deux puces interconnectées forment un dispositif à circuit intégré puce sur puce dans lequel la deuxième puce (B) est portée par la première puce (A), ces puces étant tournées l'un vers l'autre, où des signaux sont transférés de la première puce (A) à la deuxième puce (B) par l'intermédiaire d'un premier groupe de paires d'interconnexions (1 à n), et de la deuxième puce (B) à la première puce (A) par l'intermédiaire d'un deuxième groupe de paires d'interconnexions (1 à m) et en ce que le circuit de contrôle comprend, en plus dudit (premier) moyen formant un circuit de contrôle, un deuxième moyen formant un circuit de contrôle, servant à contrôler le deuxième group de paires d'interconnexions (1 à m), chaque moyen formant un circuit de contrôle possédant des bornes de vérification (17, 28), de commande (18, 29) et de détection (24, 41) qui sont toutes placées sur la première puce, le premier ainsi que le deuxième moyen formant des circuits de contrôle effectuant un contrôle séparé de chaque paire d'interconnexions desdits deux groupes (1 à n, 1 à m).

2. Circuit intégré du type puce sur puce selon la revendication 1, caractérisé en ce que:

le circuit de contrôle du premier type comprend:

plusieurs circuits de sélection (11, figure 5) placés sur la première puce (A), qui, chacun, à la réception de signal de mode de fonctionnement, séparent sensiblement le circuit de contrôle vis-à-vis d'un circuit interne de la première puce (A) et connectent une paire respective d'un premier groupe de plots d'interconnexion (1 à n) à un point de circuit interne respectif de la première puce (A), et, à la réception du signal de mode de contrôle, séparent sensiblement ledit point de circuit interne vis-à-vis de ladite paire de plots d'interconnexion et transmettent le signal de vérification, qui est appliqué à une borne de vérification respective (17), par l'intermédiaire de ladite paire de plots d'interconnexion, à la deuxième puce (B); et une porte ET à plusieurs entrées (12) placée sur

la deuxième puce (B), dont des bornes d'entrée sont respectivement fonctionnellement connectées aux paires d'interconnexions du premier groupe (1 à n), le signal de sortie de ladite porte ET à plusieurs entrées étant renvoyé à la première puce (A) et transféré à la première borne de détection (24); et

en ce que le circuit de contrôle du deuxième type comprend:

une première paire d'interconnexions (32) servant à transmettre le signal de vérification, appliqué à la borne de vérification, à la deuxième puce (B);

une deuxième paire d'interconnexions (33) servant à transmettre le signal de commande , appliqué à la borne de commande, à la deuxième puce (B);

plusieurs circuits de sélection (11, figure 6) placés sur la deuxième puce (B), qui, à la réception du signal de mode de fonctionnement en provenance de la deuxième paire d'interconnexions (33), séparent sensiblement le circuit de contrôle vis-à-vis d'un deuxième circuit interne de la deuxième puce (B) et connectent des lignes de sortie (42) du deuxième circuit interne à des paires d'interconnexions du deuxième groupe respectives (1 à m), et qui, à la réception du signal de contrôle, séparent sensiblement le deuxième circuit interne vis-à-vis desdites lignes de sortie (42) et transmettent les signaux de vérification venant de la deuxième paire d'interconnexions (33) à des paires d'interconnexions du deuxième groupe respectives (1 à m); et

plusieurs circuits de comparison (34) placés sur la première puce (A), qui, à la réception du signal de fonctionnement, sont sensiblement séparés du premier circuit interne, et, à la réception du signal de mode de contrôle, comparent les signaux apparaissant sur chacune des deuxièmes paires d'interconnexions (1 à m) avec le signal de vérification directement reçu de la borne de vérification (28).

3. Circuit intégré du type puce sur puce selon la revendication 2, caractérisé en ce que chacun desdits circuits de sélection (11) comprend:

une première porte ET (14) dont une première borne d'entrée reçoit le signal de vérification, et l'autre borne d'entrée reçoit le signal de commande;

une deuxième porte ET (15), dont une première borne d'entrée reçoit un signal de sortie de la part du circuit interne, et l'autre borne d'entrée reçoit le signal de commande inversé; et

un porte OU possédant deux bornes d'entrée respectivement connectées aux bornes de sortie des première et deuxième portes ET, et une borne de sortie fonctionnellement connectée à l'une, respective, des paires d'interconnexions à contrôler.

4. Circuit intégré du type puce sur puce selon l'une quelconque des revendications 2 et 3, caractérisé en ce que chacun desdits circuits de comparison (34) comprend:

une troisième port ET (35) possédant des bornes d'entrée qui reçoivent respectivement le signal de vérification et le signal de commande;

une quatrième porte ET (36) dont une borne d'entrée reçoit le signal de commande et l'autre borne d'entrée reçoit les signaux venant de l'une, respective, desdites paires d'interconnexions du deuxième groupe (1 à m); et

un circuit OU EXCLUSIF (37) possédant des bornes d'entrée respectivement connectées aux bornes de sortie des troisième et quatrième portes ET, et une borne de sortie fonctionnellement connectée à la deuxième borne de détection (41).

5. Circuit intégré du type puce sur puce selon l'une quelconque des revendications 2 à 4, caractérisé en ce qu'il comprend en outre un moyen de commutation (38) servant à faire commuter, l'une après l'autre, les sorties desdits circuits de comparaison (34) sur ladite deuxième borne de détection (41).

6. Circuit intégré du type puce sur puce selon la revendication 5, caractérisé en ce que ledit moyen de commutation comprend un réseau de portes de commutation (SW) comprenant des transistors à effet de champ de type p et de type n connectés en parallèle.

7. Circuit intégré du type puce sur puce selon l'une quelconque des revendications 2 à 6, caractérisé en ce que les nombres desdits circuits de sélection (11) se trouvant dans les circuits de contrôle du premier type et du deuxième type sont respectivement égaux au nombre (n) desdites paires d'interconnexions du premier groupe et au nombre (m) des paires d'interconnexions du deuxième groupe, et le nombre des bornes d'entrée de la porte ET à plusieurs entrées (12) est égal au nombre (n) des paires d'interconnexions du premier groupe.

8. Circuit intégré du type puce sur puce selon l'une quelconque des revendications 2 à 7, caractérisé en ce que les plots d'interconnexion utilisés pour les bornes de vérification (17) du circuit de contrôle du premier type sont en commun avec les plots d'interconnexion du circuit entégré initial.

# FIG. 1

# FIG. 2

Chip B

Chip A

# FIG. 3

# FIG. 4

# FIG. 5

FIG. 6

# FIG. 7